# EUROPÄISCHE PATENTANMELDUNG

(11) **EP 1 526 057 A2**
(43) Veröffentlichungstag der Anmeldung: **27.04.2005**
(21) Anmeldenummer: 04023436.1
(22) Anmeldetag: 01.10.2004
(51) Int. Cl.: B61L 15/00, F21S 10/02, F21S 8/10

(54) **LED-Signalleuchte für Schienenfahrzeuge**

(30) Priorität: 02.10.2003 DE 10347463
(71) Anmelder: Pintsch Bamag Antriebs- und Verkehrstechnik GmbH, 46537 Dinslaken (DE)
(72) Erfinder: Krause, Werner ipl.-Ing., 46535 Dinslaken (DE)
(74) Vertreter: Patentanwälte Ruff, Wilhelm, Beier, Dauster & Partner

(57) **Zusammenfassung**

2.1. Die Erfindung betrifft eine LED-Signalleuchte für Schienenfahrzeuge mit wenigstens einer ersten LED, die vom Menschen als weiß empfundenes Licht abstrahlt.
2.2. Erfindungsgemäß ist wenigstens eine zweite LED, die grünes Licht abstrahlt, wenigstens eine dritte LED, die gelbes Licht abstrahlt, sowie wenigstens eine vierte LED vorgesehen, die rotes Licht abstrahlt, worin die wenigstens eine erste, zweite, dritte und vierte LED in einem Weißlichtbetrieb gleichzeitig Licht abstrahlen.
2.3. Verwendung zur Verbesserung der Farberkennbarkeit von Retroreflexsignalen.

## Beschreibung

Die Erfindung betrifft eine LED-Signalleuchte für Schienenfahrzeuge mit wenigstens einer ersten LED, die vom Menschen als weiß empfundenes Licht abstrahlt.

Signalleuchten für Schienenfahrzeuge, die als Leuchtmittel lichtemittierende Dioden, sogenannte LEDs, verwenden, sind bekannt. Darüber hinaus sind sogenannte weiße Hochleistungs-LEDs bekannt, die vom Menschen als weiß empfundenes Licht abstrahlen und eine so hohe Lichtstärke aufweisen, dass sie als Fahrlicht verwendet werden können. Solche sogenannten weißen LEDs bestehen aus einer blauen LED und einer Phosphorschicht, die einen Teil des blauen Lichtes in gelbes Licht verwandelt. Dieses Prinzip ähnelt dem von Leuchtstofflampen, bei denen nach dem gleichen Prinzip die ultraviolette Strahlung der Quecksilberdampfniederdruckentladung mit einem oder mehreren Phosphoren in vom Menschen als weiß empfundenes Licht umgesetzt wird. Dass das Licht derartiger Leuchten vom Menschen als weiß empfunden wird hängt mit der Physiologie des menschlichen Auges zusammen, die das entstehende Mischlicht als weiß empfindet, obwohl nur ein diskretes Linienspektrum vorhanden ist.

In der Bahntechnik werden neben aktiven, lichtaussendenden Signalen auch Signale mit retroreflektierenden Materialien verwendet. Unter retroreflektierenden Materialien versteht man Materialien, bei denen der Lichtaustrittswinkel weitgehend mit dem Lichteintrittswinkel identisch ist. Diese Materialien können eingefärbt sein, so dass bei der Beleuchtung mit weißem Licht farbiges Licht zurückgestrahlt wird. In der Bahntechnik sind beispielsweise rote, gelbe, weiße und grüne retroreflektierende Materialien gängig. Die Farberkennbarkeit von Retroreflexsignalen ist bei Verwendung von weißen Hochleistungs-LEDs problematisch.

Aus der deutschen Offenlegungsschrift DE 39 16 875 A1 ist eine Signalleuchte für Kraftfahrzeuge bekannt, bei der drei Leuchtdioden in den Farben grün, rot und blau so zusammengefasst und mit einer Mischoptik versehen werden sollen, dass das abgegebene Licht als gemeinsame Lichtquelle erscheint, die je nach Beschaltung der Leuchtdioden alle auf dem Kraftfahrzeugsektor möglichen Signalfarben zu realisieren gestattet.

Mit der Erfindung soll eine LED-Signalleuchte für Schienenfahrzeuge geschaffen werden, die eine einwandfreie Farberkennbarkeit von Retroreflexsignal ermöglicht und deren Licht vom Menschen als weiß empfunden wird.

Erfindungsgemäß ist hierzu eine LED-Signalleuchte für Schienenfahrzeuge mit wenigstens einer ersten LED, die vom Menschen als weiß empfundenes Licht abstrahlt, vorgesehen, bei der wenigstens eine zweite LED, die grünes Licht abstrahlt, wenigstens eine dritte LED, die gelbes Licht abstrahlt, sowie wenigstens eine vierte LED, die rotes Licht abstrahlt, vorgesehen sind, worin die wenigstens eine erste, zweite, dritte und vierte LED in einem Weißlichtbetrieb gleichzeitig Licht abstrahlen.

Durch diese Maßnahmen wird eine Signalleuchte geschaffen, die Licht abgibt, das innerhalb der erlaubten Farborte für Signale im Schienenverkehr gemäß DIN 6163-4 liegt und mit der die Farben von Retroreflexsignalen problemlos erkannt werden können.

In Weiterbildung der Erfindung ist eine den LEDs vorgelagerte Optik vorgesehen.

Beispielsweise kann eine Streuscheibe vorgelagert sein, die das Licht der unterschiedlich farbigen LEDs mischt, so dass wenigstens in einem gewissen Abstand von der Signalleuchte eine weiße Signalscheibe wahrnehmbar ist.

In Weiterbildung der Erfindung sind die mehreren LEDs räumlich gesehen in möglichst geringem Abstand zueinander angeordnet.

Durch diese Maßnahme wird erreicht, dass die unterschiedlich farbigen Lichtpunkte der LEDs für den Betrachter so gut wie möglich miteinander verschmelzen, so dass der Abstand, aus dem die einzelnen Leuchtdioden noch als unterschiedlich farbig wahrgenommen werden können, sehr klein ist. Vorteilhafterweise werden möglichst kleine Farbpunkte verwendet, die möglichst dicht zusammen angeordnet sind.

In Weiterbildung der Erfindung sind die mehreren LEDs mittels Halbleiterchips realisiert und in einem gemeinsamen Gehäuse angeordnet.

Auf diese Weise kann ein äußerst kompakter Aufbau realisiert werden und idealerweise können konventionelle Leuchtengehäuse erfindungsgemäß umgerüstet werden, indem eine konventionell vorhandene Glühbirne durch die mehreren, unterschiedlich farbigen LEDs mit einer Mischoptik ersetzt wird.

In Weiterbildung der Erfindung weisen die mehreren LEDs bezüglich ihrer Lichtabstrahlung im wesentlichen den gleichen Öffnungswinkel auf.

Durch diese Maßnahmen können farbige Schleiereffekte bei Betrachtungswinkeln der Signalleuchte, die von einer Längsachse abweichen, vermieden werden.

In Weiterbildung der Erfindung sind wenigstens die zweite LED, die grünes Licht abstrahlt, und die vierte LED, die rotes Licht abstrahlt, getrennt von der ersten und der zweiten LED schaltbar.

Auf diese Weise können mit der erfindungsgemäßen LED-Signalleuchte neben dem weißen Signallicht auch grüne und rote Signallichter realisiert werden. Dabei kann es erforderlich sein, die einzelnen farbigen LEDs je nach gewählter Farbe und Leuchtfunktion so anzusteuern, dass unterschiedliche Lichtstärken erzielt werden.

Wird beispielsweise eine Absenkung der Lichtstärke des weißen Signallichtes gefordert, so sind gleichzeitig die Lichtstärken der zweiten grünen LED, der dritten gelben LED sowie der vierten roten LED so anzupassen, dass der gewünschte Farbort erhalten bleibt und dennoch ausreichend rote und grüne Spektralanteile im abgestrahlten Licht vorhanden sind, um die einwandfreie Farberkennbarkeit von Retroreflexsignalen zu ermöglichen.

Weitere Merkmale und Vorteile der Erfindung ergeben sich aus den Ansprüchen und der folgenden Beschreibung einer bevorzugten Ausführungsform der Erfindung in Zusammenhang mit den Zeichnungen. In den Zeichnungen zeigen:
- Fig. 1: eine schematische Draufsicht auf eine erfindungsgemäße LED-Signalleuchte,
- Fig. 2: das Lichtspektrum der Signalleuchte der Fig. 1,
- Fig. 3: ein Lichtspektrum einer weißen LED und
- Fig. 4: eine Normfarbtafel nach DIN 5033 Teil 3 mit den im Schienenverkehr erlaubten Farborten für Signale gemäß DIN 6163 Teil 4.

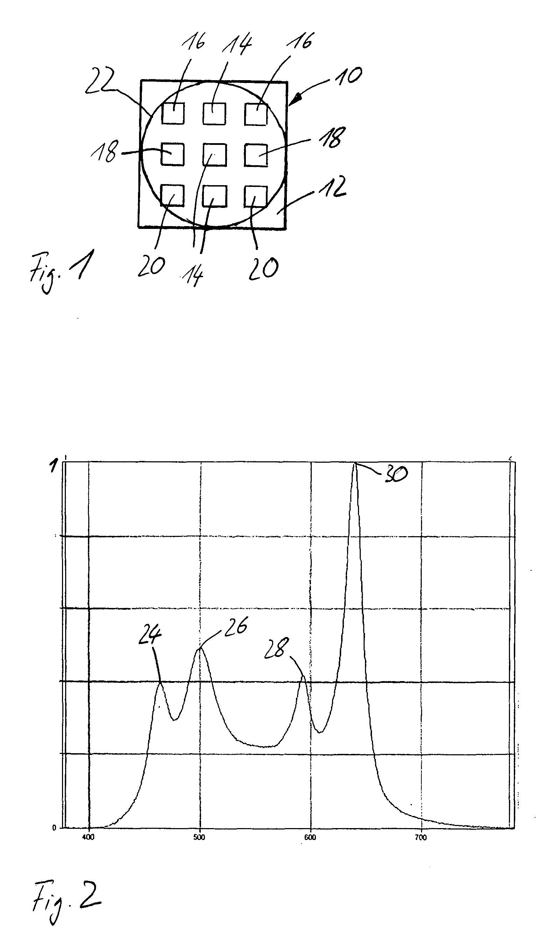

In der Darstellung der Fig. 1 ist eine LED-Signalleuchte 10 gemäß der Erfindung zu erkennen. In der schematischen Darstellung der Fig. 1 ist ein Gehäuse 12 dargestellt, in dem mehrere Halbleiterchips angeordnet sind. Jeder der Halbleiterchips stellt eine lichtemittierende Diode, eine sogenannte LED 14, 16, 18, 20 dar, die Licht abgeben kann. Drei der Halbleiterchips sind als sogenannte weiße LEDs 14 ausgebildet und geben vom Menschen als weiß empfundenes Licht ab. Dies wird mittels einer tatsächlich blaues Licht abgebenden lichtemittierenden Diode realisiert, der eine Phosphorschicht vorgelagert ist, die einen Teil des blauen Lichts in gelbes Licht verwandelt. Insgesamt wird das von den LEDs 14 abgegebene Mischlicht vom menschlichen Auge als weiß empfunden, obwohl nur ein diskretes Linienspektrum vorhanden ist. Die LEDs 16 geben gelbes Licht ab, die LEDs 18 geben rotes Licht ab und die LEDs 20 geben grünes Licht ab.

Lediglich der besseren Erkennbarkeit halber sind die LEDs 14, 16, 18 und 20 in einem Abstand zueinander dargestellt. Tatsächlich wird der Abstand zwischen den LEDs 14, 16, 18 und 20 möglichst klein gewählt und zusätzlich wird die Größe der LEDs 14, 16, 18 und 20 möglichst klein gewählt, so dass diese lediglich bei sehr geringem Abstand als einzelne, farbige Lichtpunkte wahrnehmbar sind, in größerem Abstand die LEDs 14, 16, 18, 20 aber nur noch als weiße Lichtscheibe zu erkennen sind. Dieses Verschmelzen der Lichtpunkte der LEDs 14, 16, 18, 20 wird darüber hinaus dadurch unterstützt, dass die LEDs 14, 16, 18, 20 alle den gleichen Öffnungswinkel bezüglich ihrer jeweiligen Lichtabstrahlung aufweisen. Dadurch werden auch bei Blickwinkeln, die von der Längsachse der Signalleuchte 10 abweichen, das bedeutet in der Fig. 1 senkrecht zum Blatt, farbige Schleiereffekte vermieden. Weiterhin ist in Abstrahlrichtung der LEDs 14, 16, 18, 20 vor diesen eine Streuscheibe 22 angeordnet, die das Mischen des von den LEDs 14, 16, 18, 20 abgegebene Lichts unterstützt.

Neben weißem Signallicht kann mit der LED-Signalleuchte 10 farbiges Signallicht abgegeben werden, indem beispielsweise lediglich die roten LEDs 18 bzw. die grünen LEDs 20 eingeschaltet werden. Im Schienenverkehr kann auf die getrennte Schaltbarkeit der gelben LEDs 16 verzichtet werden, da im Schienenverkehr keine gelben Signale verwendet werden.

Sämtliche LEDs 14, 16, 18, 20 werden mittels eines gemeinsamen Steuergeräts, das nicht dargestellt ist, angesteuert. Mittels dieses Steuergeräts wird nicht nur das getrennte Schalten der roten LEDs 18 und der grünen LEDs 20 realisiert, sondern darüber hinaus auch eine Absenkung der abgegebenen Lichtstärke ermöglicht. So senkt das Steuergerät im Weißlichtbetrieb, wenn beispielsweise eine geringere Leuchtstärke gefordert ist, gleichzeitig die von den gelben LEDs 16, den roten LEDs 18 und den grünen LEDs 20 abgegebene Lichtstärke ab, so dass der geforderte Farbort des abgegebenen Lichts erhalten bleibt.

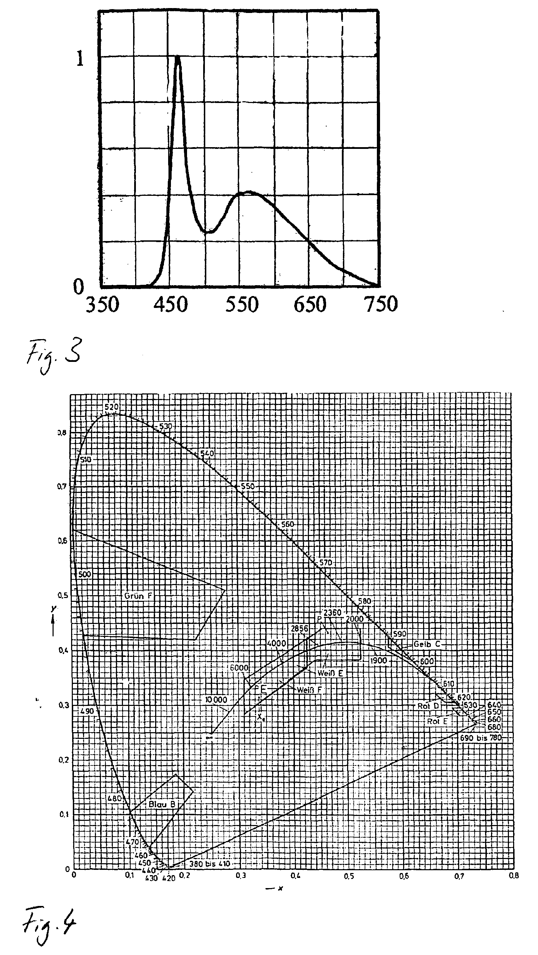

In der Darstellung der Fig. 2 ist ein typisches Lichtspektrum der Signalleuchte 10 der Fig. 1 im Weißlichtbetrieb dargestellt. Die Darstellung des Spektrums ist normiert und über der Wellenlänge aufgetragen. Das dargestellte Spektrum weist einen ersten Peak 24 bei etwa 470nm auf. Dieser Peak 24 wird hauptsächlich durch die weißen LEDs 14 bestimmt, deren Lichtspektrum in dem Diagramm der Fig. 3 dargestellt ist. Speziell wird dieser erste Peak 24 durch den hohen Blauanteil der weißen LEDs 14 bestimmt und kann in einem Bereich zwischen 465 nm und 480 nm liegen. Ein zweiter Peak 26 im Kurvenverlauf der Fig. 2 bei etwa 500nm wird hauptsächlich von den grünen LEDs 20 bestimmt. Dieser zweite Peak 26 kann alternativ auch im Bereich zwischen 500nm und 550 nm liegen. Ein weiterer dritter Peak 28 folgt bei etwa 580nm. Dieser dritte Peak 28 wird hauptsächlich von den gelben LEDs 16 bestimmt, die auch als Amber-LED bezeichnet werden und kann in einem Bereich zwischen 575 nm und 590 nm liegen. Ein vierter letzter Peak 30 im Kurvenverlauf der Fig. 2 folgt bei etwa 630nm und ist hauptsächlich durch die roten LEDs 18 bestimmt. Dieser vierte Peak 30 kann in einem Bereich zwischen 630 nm und 640 nm liegen. Insgesamt ergibt sich ein Verlauf des von der Signalleuchte 10 abgegebenen Lichtspektrums, das einerseits den in der Fig. 4 dargestellten Farbort "weißF" erreicht und andererseits auch rote, gelbe (Amber) und grüne Spektralanteile in nennenswerten Maß aufweist, so dass eine problemlose Farberkennbarkeit von Retroreflexsignalen gewährleistet ist.

Dabei ist festzustellen, dass ausgehend vom in der Fig. 3 dargestellten Spektrum der weißen LEDs 14 der Farbort "weißF" gemäß Fig. 4 bereits durch Hinzufügen der gelben LEDs 16, die hauptsächlich den Peak 28 im Kurvenverlauf der Fig. 2 bestimmen, erreicht werden kann. Werden zusätzlich noch nennenswerte rote Spektralanteile durch die roten LEDs 18 hinzugefügt, wird zwar die Farberkennbarkeit von Retroreflexsignalen wesentlich verbessert, der Farbort "weißF" in der Darstellung der Fig. 4 wird aber nicht mehr erreicht. Erst durch den zusätzlichen Betrieb der grünen Leuchtdioden 20 wird der Farbort "weißF" in der Darstellung der Fig. 4 wieder erreicht und gleichzeitig ist die zuverlässige Farberkennbarkeit von Retroreflexsignalen sichergestellt.

In dem Diagramm der Fig. 2 ist dabei die relative Lichtstärke über der Wellenlänge aufgetragen. Die Höhe der Peaks 24, 26, 28 und 30 bestimmt sich demzufolge nach dem Verhältnis der Anzahl der weißen, grünen, gelben bzw. roten LEDs 14, 20, 16, 18 zur Gesamtanzahl der LEDs 14, 20, 16, 18. Beispielsweise kann die Höhe des grünen, zweiten Peaks 26 im Kurvenverlauf der Fig. 2 dadurch erhöht werden, dass relativ zur Gesamtanzahl aller LEDs mehr grüne LEDs 20 vorgesehen werden. Der Kurvenverlauf in der Fig. 2 und somit die relative Höhe der Peaks 24, 26, 28, 30 ist dabei so festgelegt, dass sich nach Verknüpfung mit der Taglicht-Empfindlichkeitskurve des menschlichen Auges der Farbort "weißF" im Diagramm der Fig. 4 ergibt. Die absolute Lichtstärke des abgegebenen Signallichts kann durch Erhöhung der Gesamtzahl der vorgesehenen LEDs erreicht werden wobei dann, um den Farbort "weißF" weiterhin zu erreichen, darauf geachtet werden muss, das Verhältnis der weißen, grünen, gelben und roten LEDs 14, 20, 16, 18 untereinander nicht zu verändern.

## Patentansprüche

1. LED-Signalleuchte für Schienenfahrzeuge mit wenigstens einer ersten LED (14), die vom Menschen als weiß empfundenes Licht abstrahlt, **dadurch gekennzeichnet, dass** wenigstens eine zweite LED (20), die grünes Licht abstrahlt, wenigstens eine dritte LED (16), die gelbes Licht abstrahlt, sowie wenigstens eine vierte LED (18), die rotes Licht abstrahlt, vorgesehen sind, worin die wenigstens eine erste, zweite, dritte und vierte LED (14, 16, 18, 20) in einem Weißlichtbetrieb gleichzeitig Licht abstrahlen.

2. LED-Signalleuchte nach Anspruch 1, **dadurch gekennzeichnet, dass** eine den LEDs (14, 16, 18, 20) vorgelagerte Optik (22) vorgesehen ist.

3. LED-Signalleuchte nach Anspruch 2, **dadurch gekennzeichnet, dass** die Optik (22) als Streuscheibe ausgebildet ist.

4. LED-Signalleuchte nach wenigstens einem der vorstehenden Ansprüche **dadurch gekennzeichnet, dass** die mehreren LEDs (14, 16, 18, 20) räumlich gesehen in möglichst geringem Abstand zueinander angeordnet sind.

5. LED-Signalleuchte nach wenigstens einem der vorstehenden Ansprüche, **dadurch gekennzeichnet, dass** die mehreren LEDs (14, 16, 18, 20) mittels Halbleiterchips realisiert und in einem gemeinsamen Gehäuse (12) angeordnet sind.

6. LED-Signalleuchte nach wenigstens einem der vorstehenden Ansprüche, **dadurch gekennzeichnet, dass** die mehreren LEDs (14, 16, 18, 20) bezüglich ihrer Lichtabstrahlung im wesentlichen den gleichen Öffnungswinkel aufweisen.

7. LED-Signalleuchte nach wenigstens einem der vorstehenden Ansprüche, **dadurch gekennzeichnet, dass** wenigstens die zweite LED (20), die grünes Licht abstrahlt, und die vierte LED (18), die rotes Licht abstrahlt, getrennt von der ersten und der zweiten LED (14, 16) schaltbar sind.

8. LED-Signalleuchte nach wenigstens einem der vorstehenden Ansprüche, **dadurch gekennzeichnet, dass** ein abgestrahltes Lichtspektrum einem ersten Peak (24) im Bereich von 465 nm bis 480 nm, insbesondere bei 470 nm, aufweist.

9. LED-Signalleuchte nach wenigstens einem der vorstehenden Ansprüche, **dadurch gekennzeichnet, dass** ein abgestrahltes Lichtspektrum einen zweiten Peak (26) im Bereich zwischen 500 nm und 550 nm, insbesondere bei 500 nm, aufweist.

10. LED-Signalleuchte nach wenigstens einem der vorstehenden Ansprüche, **dadurch gekennzeichnet, dass** ein abgestrahltes Lichtspektrum einen dritten Peak (28) im Bereich zwischen 575 nm und 590 nm, insbesondere bei 580 nm, aufweist.

11. LED-Signalleuchte nach wenigstens einem der vorstehenden Ansprüche, **dadurch gekennzeichnet, dass** ein abgestrahltes Lichtspektrum einen vierten Peak (30) im Bereich zwischen 630 nm und 640 nm, insbesondere bei 630 nm, aufweist.

12. LED-Signalleuchte nach Anspruch 8, 9, 10 und 11, **dadurch gekennzeichnet, dass** eine von den weißen LEDs (14) abgegebene Lichtstärke, eine von den grünen LEDs (20) abgegebene Lichtstärke, eine von den gelben LEDs (16) und eine von den roten LEDs (18) abgegebene Lichtstärke so aufeinander abgestimmt sind, entsprechend der relativen Höhe des ersten, zweiten, dritten und vierten Peaks (24, 26, 28, 30), so dass das abgegebene Signallicht den Farbort "weißF" erreicht.
